# EUROPÄISCHE PATENTSCHRIFT

(11) **EP 0 404 789 B1**
(45) Veröffentlichungstag und Bekanntmachung des Hinweises auf die Patenterteilung: **26.05.1993**
(21) Anmeldenummer: 89903087.8
(22) Anmeldetag: 15.03.1989
(51) Int. Cl.: H01L 25/075, G06K 15/12

(54) **MONTAGEVERFAHREN ZUR HERSTELLUNG VON LED-ZEILEN**
ASSEMBLY PROCESS FOR PRODUCING LED ROWS
PROCEDE DE MONTAGE POUR LA FABRICATION DE RANGEES DE DIODES ELECTROLUMINESCENTES

(30) Priorität: 15.03.1988 DE 3808667
(43) Veröffentlichungstag der Anmeldung: 02.01.1991
(73) Patentinhaber: Siemens Nixdorf Informationssysteme Aktiengesellschaft, 33102 Paderborn (DE)
(72) Erfinder: HACKE, Hans-Jürgen, D-8000 München 71 (DE); MAIER, Manfred, D-8000 München 45 (DE); UNGER, Gregor, D-8034 Germering (DE); WIRBSER, Oscar, D-8034 Germering (DE)
(74) Vertreter: Fuchs, Franz-Josef, Dr.-Ing.
(86) Internationale Anmeldenummer: DE8900163
(87) Internationale Veröffentlichungsnummer: WO8908927

(56) Entgegenhaltungen:
- EP-A- 0 125 632
- DE-A- 3 009 985
- GB-A- 2 156 153
- PATENT ABSTRACTS OF JAPAN, vol. 7, no. 63, (M-200)(1208), 16 March 1983 ; & JP-A-57207076 2.
- IEEE TRANSACTIONS ON COMPONENTS, HYBRIDS AND MANUFACTURING TECHNOLOGY, vol. CHMT-8, No. 4, December 1985 ; H. Tanabe et al : "High accuracy die-bonding technology for LED array", pages 500-504.

## Beschreibung

Die Erfindung betrifft ein Montageverfahren zur Herstellung von LED-Zeilen, insbesondere für den Zeichengenerator eines nichtmechanischen Druckers.

Unter LED-Zeilen versteht man üblicherweise die Anordnung von LEDs, das heißt von lichtemittierenden Dioden, in Zeilenform. Ursprünglich hat man diskrete Einzelkomponenten zu Zeilen montiert. Damit konnte man nur ein grobes Raster von zum Beispiel 1/10, 1/20 Zoll aus fertig gekapselten LEDs realisieren. Später wurden einzeln ungekapselte LED-Chips zu Zeilen montiert, mit denen man dann wesentlich feinere Raster verwirklichen konnte. Heute ist es durch Integration auf der Halbleiterscheibe möglich, LEDs mit extrem hoher Punktdichte anzuordnen, zum Beispiel 300 oder 600 dpi (dots per inch).

Wegen Beschränkung in der Halbleiterscheibengröße und aus Ausbeutegründen ist es nur möglich, kleinere Streifenabschnitte derartig integrierter LED-Zeilen herzustellen. Um nun lange LED-Zeilen, zum Beispiel für Druckzwecke, herzustellen, müssen mehrere derartige Abschnitte sehr genau zueinander passend montiert werden.

Üblicherweise werden LEDs zu Anzeigezwecken benutzt. Beispielsweise aus der DE-A- 35 34 338 ist es aber auch schon bekannt, LEDs zu Druckzwecken bei einem Zeichengenerator für einen nichtmechanischen Drucker zu verwenden. Der dort beschriebene Zeichengenerator enthält in einer Belichtungszeile eine Vielzahl von Lichtquellen, die beispielsweise als Leuchtdioden ausgebildet sind. Unter Verwendung der Lichtquellen wird auf einer Umdrucktrommel ein latentes elektrostatisches Bild erzeugt. Bei dem bekannten Zeichengenerator sind alle die Belichtungszeile bildenden Bauteile, wie die Leuchtdioden, Ansteuerschaltungen und Zuleitungen auf einem gemeinsamen Träger fest montiert, wobei die Befestigung der Leuchtdioden und Ansteuerschaltungen durch Kleben vorgenommen wird. Der Träger hat dabei eine Länge, die mindestens so groß ist, wie die Breite der ganzen Belichtungszeile.

Bei Zeichengeneratoren erfordert die Nutzung der LEDs als bildgebende Elemente bei der hohen Punktdichte von bis zu 600 dpi die Einhaltung engster Toleranzen in allen drei Richtungen, also hinsichtlich Teilungsabstand, Linientreue und Oberflächenplanität. Zum anderen wird zur Abfuhr der hohen Verlustwärme aus den LEDs eine optimale, thermische Ankopplung an einen aus Metall bestehenden Träger benötigt. Diese Forderungen sind aber mit den bisher bekannten Herstellungsverfahren nicht oder nicht ohne weiteres zu erfüllen. So ermöglicht das Aufkleben von LED-Chips auf einen Träger zwar durch eine vorhergehende Justierung die geforderte Einhaltung engster Toleranzen in allen drei Richtungen, wobei hier jedoch der Klebstoff die zur Ableitung der Verlustwärme erforderliche optimale thermische Ankopplung verhindert. Andererseits ermöglicht ein Auflöten der LED-Chips auf einen Metallträger eine optimale thermische Ankopplung, wobei hier jedoch beim Auflöten eines LED-Chips das Erweichen oder Wiederaufschmelzen der Lötverbindung des benachbarten LED-Chips zwangsläufig zu dessen Dejustierung führt.

Aus DE-A-3 009 985 ist ein Verfahren zur Herstellung von LED-Zeilen bekannt, bei dem eine LED- Scheibe auf einer geeigneten Unterlage befestigt und die LED-Scheibe Zertrennt wird, wobei die einzelnen LED-Chips erzeugt werden.

Der Erfindung liegt die Aufgabe zugrunde, ein Montageverfahren zur Herstellung von LED-Zeilen zu schaffen, das einerseits die Einhaltung engster Toleranzen im Hinblick auf Teilungsabstand, Linientreue und Oberflächenplanität ermöglicht und andererseits durch eine optimale thermische Ankopplung an einen Metallträger eine Abfuhr der hohen Verlustwärme aus den LEDs gewährleistet.

Diese Aufgabe wird bei einem gattungsgemäßen Montageverfahren durch die im Anspruch 1 aufgeführten Verfahrensschritte gelöst.

Mit anderen Worten werden bei dem erfindungsgemäßen Montageverfahren die LEDs über ein Transferverfahren auf den Metallträger aufgebracht. Dieses Transferverfahren ermöglicht einerseits, daß die LEDs mit hoher Genauigkeit in allen drei Richtungen zeilenförmig auf den Hilfsträger aufgebracht werden können und daß andererseits durch das Löten eine thermisch gut leitende Verbindung mit dem Metallträger gewährleistet ist. Dabei ist es möglich, auch relativ große Unterschiede in der Dicke der LEDs auszugleichen, ohne daß sich diese Dickenunterschiede auf der Zeilenoberfläche als Stufen bemerkbar machen.

Vorteilhafte Ausführungsformen und Weiterbildungen der Erfindung sind in den Unteransprüchen enthalten.

Ausführungsbeispiele der Erfindung sind in der Zeichnung dargestellt und werden im folgenden näher beschrieben.

Es zeigen:
Figur 1 einen im Querschnitt dargestellten, prinzipiellen Teilaufbau eines elektrofotografischen Druckers zum Erzeugen eines latenten, elektrostatischen Bildes,
Figur 2 die Draufsicht auf einen Belichtungsmodul mit LED-Zeile des Druckers gemäß Figur 1,
Figur 3 das Aufbringen von LED-Chips in der für den Belichtungsmodul gemäß Figur 2 erforderlichen Zeilenform auf einen Hilfsträger,
Figur 4 den Fügebereich zweier auf dem Hilfsträger gemäß Figur 3 angeordneter LED-Chips,
Figur 5 den Fügebereich zweier auf einer zweiten Ausführungsform des Hilfsträgers angeordneter LED-Chips,
Figur 6 den Transfer der auf dem Hilfsträger in Zeilenform angeordneten LED-Chips auf einen Metallträger und
Figur 7 die fertige Anordnung der für den Belichtungsmodul gemäß Figur 2 benötigten LED-Zeile auf dem Metallträger.

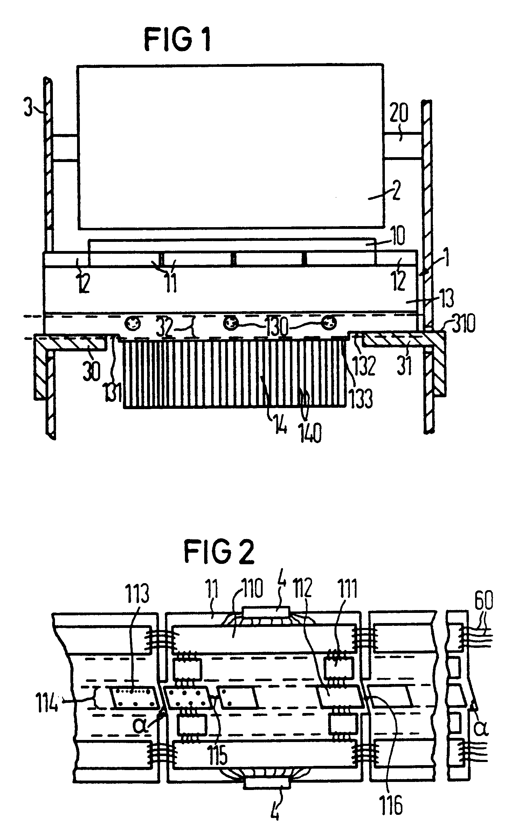

Die Figur 1 zeigt, wie ein Zeichengenerator 1 und eine Umdrucktrommel 2 in einem Druckergehäuse 3 eines Druckers eingebaut sind. Die Umdrucktrommel 2 ist dazu auf einer im Druckergehäuse 3 rotierbar gelagerten Spindel 20 axial festgelegt. Unterhalb der drehbar gelagerten Umdrucktrommel 2 ist der Zeichengenerator 1 in dem Druckergehäuse 3 befestigt. Der Zeichengenerator 1 ist dazu an seinen beiden Enden auf justierbaren Befestigungselementen 30, 31 fest montiert.

Eine Abbildungsoptik 10 des Zeichengenerators 1 reproduziert Bildpunkte von im folgenden mit LEDs bezeichneten lichtemittierenden Dioden auf die Umdrucktrommel 2. Angeordnet sind diese LEDs jeweils auf einem Belichtungsmodul 11, das mit dem Steg eines T-förmig ausgebildeten Modulträgers 13 formschlüssig verbunden ist. Auf dem Steg des Modulträgers 13 sind weiterhin Anschlagelemente 12 vorgesehen, die ein Verschieben der Belichtungsmodule 11 im Betriebszustand des Zeichengenerators 1 in horizontaler Richtung verhindern. Der Flansch des T-förmig ausgebildeten Modulträgers 13 weist zudem Laufrollen 130 auf, die jeweils paarweise an den beiden langen Stirnflächenseiten des Flansches diametral zueinander befestigt sind. Darüber hinaus gliedert sich die Grundfläche des Flansches in zwei Auflageflächen 131, 132 sowie einer von diesen beiden Auflageflächen 131, 132 abgesetzten Stufenfläche 133 auf, auf der mehrere einen Kühlkörper 14 bildende Kühlrippen 140 befestigt, beispielsweise angelötet, sind.

Für den Betrieb des Druckers wird der Zeichengenerator dadurch, daß die Laufrollen 130 in Führungsschienen 32 des Druckergehäuses 3 in horizontaler Richtung bewegbar sind, so weit in das Druckergehäuse 3 eingeschoben, bis der Zeichengenerator 1 in den Befestigungsebenen 300, 310 mit seinen Auflageflächen 131, 132 auf den Befestigungselementen 30, 31 aufliegt.

Um mit dem Zeichengenerator 1 latente, elektrostatische Bilder auf der Umdrucktrommel 2 zu erzeugen, und dadurch letztlich auf einem Aufzeichnungsträger beliebige Zeichen drucken zu können, sind auf den Belichtungsmodulen 11, wie die Figur 2 zeigt, in einer LED-Zeile bzw. Belichtungszeile 114 in einem regelmäßigen Abstand die LEDs 113 als LED-Chips 112 mit paarweise parallelen Seiten und je nach Druckraster mit 64 oder 128 enthaltenen LEDs monolithisch integriert. Stellvertretend hierfür sind in Figur 2 Punkte als LEDs eingezeichnet. Die einzelnen LEDs in der Belichtungszeile 114 bzw. auf den LED-Chips 112 sind in zwei in einem äquidistanten Abstand verlaufenden Reihen jeweils versetzt angeordnet. Bestimmt wird dieser Versatz in Abhängigkeit vom Druckraster. Typische verwendete Druckraster sind z.B. 240 dpi (dots per inch), 300 dpi und 600 dpi. Das Versetzen der LEDs 113 ist unter anderem deshalb erforderlich, weil der Durchmesser der LEDs 113 für die genannten Druckraster größer ist, als der daraus resultierende Versatz und deshalb die LEDs 113 nicht in einer einreihigen, durchgehenden Belichtungszeile 114 angeordnet werden können. Im übrigen ist die Zahl 64 bzw. 128 für die Anzahl der LEDs 113 pro LED-Chip 112 auf den Modulen 11 des Zeichengenerators 1 nicht willkürlich gewählt, sondern orientiert sich an Gegebenheiten, die mit der digitalen Ansteuerung der LEDs 113 zusammenhängen. Für diese digitale Ansteuerung ist für jede LED-Reihe eines LED-Chips 112 auf dem Modul 11, wie in Figur 2 zu sehen ist, ein integrierter Schaltkreis 111 vorgesehen. Jeder dieser integrierten Schaltkreise 111 ist über ein Bussystem 110 sowohl mit einer flexiblen Flachbandleitung 4 als auch über nicht dargestellte Treiberbausteine mit Daten und Steuerleitungen 60 verbunden und damit an eine ebenfalls nicht dargestellte Stromversorgung bzw. eine mikroprozessorgesteuerte Einrichtung angeschlossen. In dieser Einrichtung werden sämtliche Druckdaten von den LEDs 113 in der Belichtungszeile 114 gespeichert und aufbereitet.

Im Hinblick auf den vorstehend erwähnten Versatz zwischen den LEDs 113 der oberen Reihe und den LEDs 113 der unteren Reihe sind die LED-Chips 112 im Bereich ihrer Stoßflächen um Winkel α = 76^{o} abgeschrägt, so wie es in Figur 2 zu erkennen ist. Entsprechend der Moduleinteilung wird der Rohling, aus dem die einzelnen Belichtungsmodule 11 gefertigt werden, unter dem Winkel α im Bereich der Belichtungszeile 114 besonders sorgfältig durchgetrennt und danach noch mit höchster Toleranzgenauigkeit mechanisch bearbeitet. Dieses ist deshalb erforderlich, damit die durch die mechanische Bearbeitung entstehenden Fügeflächen 116 die Homogenität der gesamten Belichtungszeile 114 über alle Belichtungsmodule 11 des Zeichengenerators 1 beim Verspannen der Module 11 in horizontaler Richtung nicht nachteilig beeinflussen. Daß diese Fügeflächen 116 sich nicht nachteilig auf die Homogenität auswirken, ist andererseits erst durch einen genügend großen Fügespalt 115 zwischen den einzelnen Chips 112 auf jedem Modul 11 gegeben.

Das der Herstellung von LED-Zeilen 114 zugrundeliegende Problem wird dadurch gelöst, daß zur optimalen thermischen Ankopplung die LEDs gelötet werden und daß zur Einhaltung der engen Toleranzen, insbesondere in der Höhenabweichung, die LEDs in einem Transferverfahren auf den Metallträger übertragen werden. Dazu werden die LEDs zunächst mit ihrer aktiven Seite nach unten unter Benutzung hochpräziser optischer Justiermittel zu einer Zeile auf einen ebenen Hilfsträger geklebt. Sodann wird dieser Hilfsträger mit der LED-Zeile auf den zuvor streifenförmig definiert mit lotbeschichteten massiven Metallträger so positioniert, daß die lötfähige Rückseite der LEDs zum Lot auf dem Metallträger weist. Der fixierte Verbund aus Metall- und Hilfsträger wird dann einer Wärmequelle, z.B. einer Vaporphase-Lötanlage, ausgesetzt. Dabei schmilzt das Lot auf dem Metallträger, benetzt die LED-Rückseiten und stellt die Verbindungen her. Der Hilfsträger wird nach dem Löten durch Auflösen des Klebers entfernt. Nach einem Reinigungsvorgang ist der nunmehr mit einer LED-Zeile versehene Metallträger bereit zur weiteren Verarbeitung.

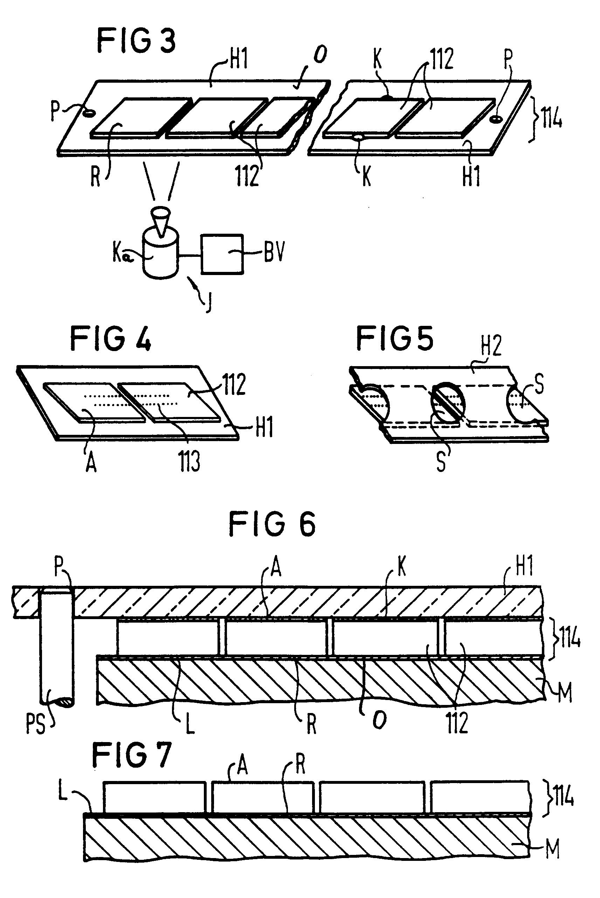

Im einzelnen werden nachfolgend die wesentlichen Schritte der vorstehend geschilderten Verfahrensweise beim Aufbringen der LED-Chips 112 in Zeilenform auf den Metallträger M des in Figur 2 dargestellten Belichtungsmoduls 11 anhand der Figuren 3 bis 7 erläutert.

Gemäß Figur 3 wird ein starrer Hilfsträger H1 verwendet, der beispielsweise eine Stärke von 1 mm aufweist und aus durchsichtigem Glas besteht. An beiden Enden des streifenförmigen Hilfsträgers H1 befinden sich Positionieröffnungen P, deren Funktion im Zusammenhang mit Figur 6 an späterer Stelle erläutert wird. Auf die plane Oberfläche O des Hilfsträgers H1 werden die einzelnen LED-Chips nacheinander mit ihrer aktiven Seite positioniert und durch Kleben fixiert, d.h. die lötfähigen Rückseiten R der LED-Chips 112 weisen nach oben. Das Aufbringen erfolgt in der Weise, daß zunächst ein erster LED-Chip 112 auf der Oberfläche O des Hilfsträgers H1 positioniert und dann mit Hilfe eines UV-härtbaren Klebers K fixiert wird, worauf der zweite LED-Chip 112 auf der Oberfläche O positioniert, relativ zum ersten LED-Chip 112 justiert und mit Hilfe des UV-härtbaren Klebers K fixiert wird. Dieser Vorgang wird fortgesetzt, bis der letzte LED-Chip 112 auf dem Hilfsträger H fixiert ist. Das Justieren der LED-Chips 112 erfolgt mit Hilfe einer optoelektronischen Justiervorrichtung J, die aus einer unterhalb des Hilfsträgers H1 angeordneten Kamera Ka und einer Bildverarbeitungseinrichtung BV besteht. Die Funktionsweise derartiger optoelektronischer Justiervorrichtungen J ist beispielsweise in der US-A- 4 305 097 beschrieben. Das Fixieren der justierten LED-Chips 112 durch Kleben ist in Figur 3 beim vorletzten LED-Chip 112 der LED-Zeile 114 aufgezeigt. Der UV-härtbare Kleber K wird zu beiden Seiten eines zu fixierenden LED-Chips 112 in Tropfenform derart appliziert, daß er durch Kapillarwirkung selbsttätig zwischen die aktive Seite A des LED-Chips 112 und die Oberfläche O des Hilfsträgers H1 eingezogen wird und unmittelbar danach mittels UV-Strahlung von unten her durch den Hilfsträger H1 hindurch ausgehärtet werden kann.

Beim Justiervorgang erfaßt die Kamera Ka jeweils durch den durchsichtigen Hilfsträger H1 hindurch den Fügebereich zweier LED-Chips 112 und die LEDs 113 auf der aktiven Seite A in diesem Fügebereich, so wie es aus Figur 4 ersichtlich ist. Beim eigentlichen Justiervorgang wird dann der noch nicht fixierte LED-Chip 112 zum vorausgegangenen bereits geklebten LED-Chip 112 beispielsweise durch Doppelbildvergleich so ausgerichtet, daß in den beiden Reihen der LEDs 113 keine Unterbrechung im Fügebereich auftritt. Gemäß der in Figur 5 dargestellten Variante kann ein hier mit H2 bezeichneter Hilfsträger auch aus Metall, wie z.B. Edelstahl, oder aus Keramik bestehen, wenn er im Fügebereich der LED-Chips 112 mit Sichtöffnungen S für die Justage der LED-Chips 112 versehen ist.

Figur 6 zeigt die Übertragung der auf dem Hilfsträger H1 lösbar befestigten LED-Zeile 114 auf den Metallträger M des Belichtungsmoduls 11 (vgl. Fig. 2). Die Positionierung des Hilfsträgers H1 relativ zum Metallträger M erfolgt mit Hilfe einer Vorrichtung, von welcher lediglich die in die Positionieröffnungen P eindringenden Positionierstifte PS zu erkennen sind. Der Metallträger M, der eine Stärke von 12 mm aufweist, besteht aus thermischen Gründen aus Kupfer, das im vorgesehenen Verbindungsbereich mit den LED-Chips 112 mit einer in der Zeichnung nicht dargestellten, galvanisch abgeschiedenen und ca. 1,5 µm starken Goldschicht versehen ist. Auf der Goldschicht befindet sich eine dünne Lotschicht L, bei welcher es sich beispielsweise um ein Zinn/Blei-Lot handelt. Die streifenförmig im Verbindungsbereich auf dem Metallträger M angeordnete Lotschicht L wird zunächst in Form einer Lotpaste durch Siebdruck aufgebracht und dann umgeschmolzen. Auf der Lotschicht L liegen die lötfähigen Rückseiten R der LED-Chips 112 auf, wobei als lötfähige Schicht eine im Vakuum auf die Rückseite R aufgedampfte, in der Zeichnung nicht erkennbare Goldschicht dient.

Der in Figur 6 dargestellte Verbund aus Metallträger M und Hilfsträger H1 wird -wie es bereits erwähnt wurde- in einer Vaporphase-Lötanlage erwärmt, bis das Lot L aufschmilzt und eine sichere Lötverbindung zwischen den Rückseiten R der LED-Chips 112 und dem Metallträger M gewährleistet ist. Beim Löten kann eventuell seitlich austretendes Lot L in Rillen des Metallträgers M aufgefangen werden, die beispielsweise 1 mm tief sind und in der Zeichnung nicht dargestellt sind.

Nach dem Löten werden der Hilfsträger H1 und der verwendete Kleber K entfernt, so daß nunmehr die in Figur 7 dargestellte fertige LED-Zeile 114 auf dem Metallträger M angeordnet ist, wobei die aktiven Seiten A nach oben weisen. Das Entfernen des Hilfsträgers H1 erfolgt auf besonders einfache Weise durch Auflösen des Klebers K in einem geeigneten Lösemittel. Für handelsübliche UV-härtbare Kleber, die beispielsweise UV-Härter auf der Basis von Hydroxylalkylphenonen aufweisen, ist beispielsweise Ethylmethylketon als Lösemittel geeignet.

## Patentansprüche

1. Montageverfahren zur Herstellung von LED-Zeilen, insbesondere für den Zeichengenerator eines nichtmechanischen Druckers, mit folgenden Verfahrensschritten:
a) LED-Chips (112) mit jeweils mindestens einer LED (113) werden mit ihrer aktiven Seite (A) in Zeilenform auf der planen Oberfläche (O) eines Hilfsträgers (H1; H2) positioniert, relativ zueinander justiert und mit Hilfe eines Klebers (K) lösbar mit dem Hilfsträger (H1; H2) verbunden;
b) die am Hilfsträger (H1; H2) befestigte LED-Zeile (114) wird mit den Rückseiten (R) der LED-Chips (112) auf einem Metallträger (M) positioniert;
c) die Rückseiten (R) der LED-Chips (112) werden mit dem Metallträger (M) durch Löten verbunden;
d) der Hilfsträger (H1; H2) und der Kleber (K) werden entfernt.

2. Montageverfahren nach Anspruch 1,
**dadurch gekennzeichnet,**
daß ein Hilfsträger (H1) aus Glas verwendet wird.

3. Montageverfahren nach Anspruch 1,
**dadurch gekennzeichnet,**
daß ein Hilfsträger (H2) aus Metall oder Keramik verwendet wird, der im Fügebereich der LED-Chips (112) mit Sichtöffnungen (S) für die Justage der LED-Chips (112) versehen ist.

4. Montageverfahren nach einem der vorhergehenden Ansprüche,
**dadurch gekennzeichnet,**
daß die Justage der LED-Chips (112) mit Hilfe einer optoelektronischen Justiervorrichtung (J) vorgenommen wird.

5. Montageverfahren nach einem der vorhergehenden Ansprüche,
**dadurch gekennzeichnet,**
daß jeweils ein LED-Chip einzeln auf dem Hilfsträger (H1, H2) positioniert, justiert und durch Applikation des Klebers (K) und anschließendes Aushärten des Klebers (K) fixiert wird.

6. Montageverfahren nach Anspruch 5,
**dadurch gekennzeichnet,**
daß ein UV-härtbarer Kleber (K) verwendet wird und jeweils vor dem Positionieren des nächsten LED-Chips (112) mittels UV-Strahlung ausgehärtet wird.

7. Montageverfahren nach einem der vorhergehenden Ansprüche,
**dadurch gekennzeichnet,**
daß der Kleber (K) in Tropfenform derart appliziert wird, daß er durch Kapillarwirkung selbsttätig zwischen die aktive Seite (A) eines LED-Chips (112) und die Oberfläche (O) des Hilfsträgers (H1) eingezogen wird.

8. Montageverfahren nach einem der vorhergehenden Ansprüche,
**dadurch gekennzeichnet,**
daß ein im Verbindungsbereich streifenförmig mit Lot (L) beschichteter Metallträger (M) verwendet wird.

9. Montageverfahren nach Anspruch 8,
**dadurch gekennzeichnet,**
daß nach dem Positionieren des Hilfsträgers (H1) mit den LED-Chips (112) auf dem Metallträger (M) die gesamte Anordnung bis zum Aufschmelzen des Lotes (L) erwärmt wird.

10. Montageverfahren nach einem der vorhergehenden Ansprüche,
**dadurch gekennzeichnet,**
daß nach dem Löten der Hilfsträger (H1; H2) durch Auflösen des Klebers (K) entfernt wird.

## Claims

1. Assembly method for producing LED rows, preferably for the character generator of a non-mechanical printer, having the following method steps:
a) LED chips (112) having in each case at least one LED (113) are positioned with their active side (A) in row form on the flat surface (O) of an auxiliary carrier (H1; H2), are adjusted relative to one another and are connected to the auxiliary carrier (H1; H2) in a detachable manner with the aid of an adhesive (K);
b) the LED row (114) which is attached to the auxiliary carrier (H1; H2) is positioned with the rear sides (R) of the LED chips (112) on a metal carrier (M);
c) the rear sides (R) of the LED chips (112) are connected to the metal carrier (M) by soldering;
d) the auxiliary carrier (H1; H2) and the adhesive (K) are removed.

2. Assembly method according to Claim 1, characterised in that a glass auxiliary carrier (H1) is used.

3. Assembly method according to Claim 1, characterised in that a metal or ceramic auxiliary carrier (H2) is used, which is provided in the joining region of the LED chips (112) with viewing openings (S) for the adjustment of the LED chips (112).

4. Assembly method according to one of the preceding claims, characterised in that the adjustment of the LED chips (112) is carried out with the aid of an optoelectronic adjustment device (J).

5. Assembly method according to one of the preceding claims, characterised in that in each case one LED chip is positioned individually on the auxiliary carrier (H1, H2), is adjusted, and is fixed by application of the adhesive (K) and by subsequent curing of the adhesive (K).

6. Assembly method according to Claim 5, characterised in that an adhesive (K) which can be cured by UV is used and is in each case cured by means of UV radiation before positioning of the next LED chip (112).

7. Assembly method according to one of the preceding claims, characterised in that the adhesive (K) is applied in drop form in such a manner that it is automatically drawn in, by the capillary effect, between the active side (A) of an LED chip (112) and the surface (O) of the auxiliary carrier (H1).

8. Assembly method according to one of the preceding claims, characterised in that a metal carrier (M) is used which is coated in the connecting region with solder (L) in the form of strips.

9. Assembly method according to Claim 8, characterised in that, once the auxiliary carrier (H1) has been positioned with the LED chips (112) on the metal carrier (M), the complete arrangement is heated until the solder (L) melts.

10. Assembly method according to one of the preceding claims, characterised in that, after soldering, the auxiliary carrier (H1; H2) is removed by dissolving the adhesive (K).

## Revendications

1. Procédé de montage pour la réalisation de rangées de LED (diodes électroluminescentes), notamment pour le générateur de caractères d'une imprimante non mécanique, comprenant les phases opératoires suivantes :
a) des puces à LED (112) ayant chacune au moins une LED (113), sont positionnées, par leur face active (A), suivant une ligne sur la surface plane (O) d'un support auxiliaire (H1 ; H2), elles sont ajustées l'une par rapport à l'autre et sont fixées de façon détachable, à l'aide d'une colle, au support auxiliaire (H1 ; H2) ;
b) la ligne (114) de LED fixée au support auxiliaire (H1 ; H2) est positionnée, par la face arrière (R) de la puce à LED (112), sur un support métallique (M) ;
c) les faces arrière (R) de la puce à LED (112) sont fixées au support métallique (M) par brasage ;
d) le support auxiliaire (H1 ; H2) et la colle (K) sont retirés.

2. Procédé de montage selon la revendication 1,
caractérisé en ce que l'on utilise le verre pour un support auxiliaire (H1).

3. Procédé de montage selon la revendication 1,
caractérisé en ce que l'on utilise le métal ou la céramique pour un support auxiliaire (H2), qui est pourvu, dans la zone constituant l'intervale entre les puces à LED (112), d'ouvertures d'observation (S) pour ajuster les puces à LED (112).

4. Procédé de montage selon l'une des revendications précédentes,
caractérisé en ce que l'ajustage des puces à LED (112) est réalisé au moyen d'un dispositif optoélectronique (J) d'ajustage.

5. Procédé de montage selon l'une des revendications précédentes,
caractérisé en ce que chacune des puces à LED individuelles est positionnée sur le support auxiliaire (H1, H2), est ajustée et est fixée par le dépôt de la colle (K) suivi par durcissement de la colle (K).

6. Procédé de montage selon la revendication 5,
caractérisé en ce qu'on utilise une colle durcissable aux UV (K) et on la durcit avant le positionnement de la puce à LED suivante (112), au moyen d'un rayonnement UV.

7. Procédé de montage selon l'une des revendications précédentes,
caractérisé en ce que la colle (K) est appliquée en forme de gouttes, pour qu'elle soit introduite automatiquement par capillarité entre la face active (A) d'une puce à LED (112) et la surface (O) du support auxiliaire (H1).

8. Procédé de montage selon l'une des revendications précédentes,
caractérisé en ce que l'on utilise un support métallique (M) en forme de bandes, recouvert de soudure (L) dans la zone de liaison.

9. Procédé de montage selon la revendication 8,
caractérisé en ce que, après le positionnement du support auxiliaire (H1), comportant les puces à LED (112), sur le support métallique (M), l'ensemble du dispositif est chauffé jusqu'à fusion de la soudure (L).

10. Procédé de montage selon l'une des revendications précédentes,
caractérisé en ce que, après la soudure, le support auxiliaire (H1 ; H2) est retiré par dissolution de la colle (K).
